Europäisches Patentamt

(19) European Patent Office

Office européen des brevets

(11) EP 0 751 399 A1

(12) **EUROPEAN PATENT APPLICATION**

(43) Date of publication:
02.01.1997 Bulletin 1997/01

(51) Int. Cl.$^6$: **G01R 33/345**, H01P 1/215

(21) Application number: 96110526.9

(22) Date of filing: 28.06.1996

(84) Designated Contracting States:
DE FR GB

(30) Priority: 28.06.1995 JP 186400/95

(71) Applicant: **MURATA MANUFACTURING CO., LTD.**
**Nagaokakyo-shi Kyoto-fu 226 (JP)**

(72) Inventors:
• **Kumatoriya, Makoto,**
**c/o Murata Manufact. Co., Ltd.**
**Nagaokakyo-shi, Kyoto-fu (JP)**
• **Fujii, Takashi,**
**c/o Murata Manufact. Co., Ltd.**
**Nagaokakyo-shi, Kyoto-fu (JP)**

(74) Representative: **Schoppe, Fritz, Dipl.-Ing.**
**Patentanwalt,**
**Georg-Kalb-Strasse 9**
**82049 Pullach bei München (DE)**

(54) **Ferromagnetic resonance measuring cavity resonator and electron spin resonance measuring apparatus having same**

(57) A ferromagnetic resonance measuring cavity resonator (10) comprises a cavity resonator (12) having a cavity (16) formed by a side wall (14). The side wall (14) is provided with an input/output hole (18) and a through-hole (20). A ferromagnetic plate (22) provided with a through-hole (24) is mounted on the outside surface of the side wall (14) such that the two through-holes (20,24) are aligned. A wafer specimen is pressed against the ferromagnetic plate (22) to face the through-hole (24). When microwaves are introduced into the cavity resonator (12), ferromagnetic resonance takes place based on the static magnetic field applied to the wafer specimen (26) and the microwaves. As a result, a ferromagnetic resonance signal is detected via the input/output hole (18).

**Fig. 1**

EP 0 751 399 A1

## Description

### BACKGROUND OF THE INVENTION

#### 1. Field of the Invention

The present invention relates to an electron spin resonance (ESR) measuring apparatus, and more particularly to a ferromagnetic resonance (FMR) measuring apparatus and a cavity resonator to be used in the ferromagnetic resonance measuring apparatus.

#### 2. Description of the Related Art

A ferromagnetic resonance (FMR) measurement is a kind of electron spin resonance (ESR) measurement and is employed for evaluating the magnetic properties of a magnetic material.

In the ferromagnetic resonance measurement, a cavity resonator having a cavity portion enclosed by a side wall is used. Microwaves are introduced into the cavity resonator, and a small spherical specimen or a small disk specimen is positioned where the intensity of the high-frequency magnetic field is maximum within the cavity resonator. Ferromagnetic resonance is caused by applying a static magnetic field while at the same time varying its strength. Based on measured ferromagnetic resonance signals, the resonance magnetic field, the ferromagnetic resonance linewidth, the saturation magnetisation, the anisotropy field and the like are obtained.

As for ferromagnetic single crystals having a narrow ferromagnetic resonance linewidth, the aforementioned method using a cavity resonator is not used. Since a material having a narrow ferromagnetic resonance linewidth gives a high signal strength, a slight frequency variation in the cavity resonator may be the cause of a major error when ferromagnetic resonance takes place in the cavity resonator equipped with such a material. Thus, precise ferromagnetic resonance signals cannot be detected. In connection with ferromagnetic single crystals having a narrow ferromagnetic resonance linewidth, the cavity resonator has difficulty measuring the true value of the ferromagnetic resonance linewidth. It is contemplated that ferromagnetic resonance linewidth is measured by reducing the volume of a specimen to be as small as possible to make the relative signal strength small. For example, in the case of a ferromagnetic single crystal film wafer specimen that is epitaxially grown on a substrate having a size of a few centimeters across, the wafer specimen is cut into an individual 1 mm by 1 mm chip. This small chip is positioned inside the cavity resonator and ferromagnetic resonance linewidth is measured.

The conventional method has drawbacks. Specifically, in order to control the ferromagnetic resonance linewidth of ferromagnetic single crystal film wafers which are mass-produced, a small chip must be cut from each individual wafer. Thus, the cutting of small chips requires additional time thereby increasing the time required for measurement. Since a small chip is cut from an individual wafer, the yield of the chip production for devices from the wafer is also degraded. In addition, although the ferromagnetic resonance linewidth of a small chip cut from the wafer can be measured, the ferromagnetic resonance linewidth in a wafer having a larger area cannot be measured.

In order to solve the above problems, Japanese Laid-open Patent Application No. 63-73174 discloses a method of using a waveguide having a non- reflective terminal on one end and IEEE Transactions on Magnetics, 25, 3488-3490, 1989 discloses a method of using a short-circuit waveguide. In these methods, ferromagnetic resonance linewidth is measured without the need for cutting small chips from a ferromagnetic single crystal film wafer measuring a few centimeters wide. Although in the former method, a commercially available electron spin resonance measuring instrument can be used for measurement with the cavity resonator section replaced with a waveguide having a nonreflective terminal, ferromagnetic resonance measurements at arbitrary positions on the wafer is difficult because the ferromagnetic single crystal film wafer itself becomes a resonator. For this reason, this method is not suitable for the control of the ferromagnetic resonance linewidth of the ferromagnetic single crystal film wafer in practice. The latter method fails to present circuit compatibility with any commercially available electron spin resonance measuring instrument, and thus a new measuring system must be constructed.

### SUMMARY OF THE INVENTION

It is therefore an object of the present invention to provide an electron spin resonance measuring apparatus having a ferromagnetic resonance measuring cavity resonator which measures the ferromagnetic resonance linewidth at any particular location on a ferromagnetic single crystal film wafer having a large area, which uses a commercially available electron spin resonance measuring instrument which does not need major modifications.

According to one aspect of the invention, a ferromagnetic resonance measuring cavity resonator includes: a cavity resonator having a cavity formed by a side wall, the side wall provided with a through- hole and an input/output hole; and a ferromagnetic plate having therein a through-hole, wherein the ferromagnetic plate is mounted on the side wall of the cavity resonator so that the through-hole formed in the side wall of the cavity resonator is aligned with the through-hole formed in the ferromagnetic plate.

In one embodiment, the through-hole of the ferromagnetic plate has substantially the same diameter as the through-hole of the side wall. Moreover, it is preferable that the diameter D of the through-hole formed in the side wall of the cavity resonator and the through-hole formed in the ferromagnetic plate is within the range of 0.0 < D ≦ 3.0 (mm).

According to another aspect of the invention, an electron spin resonance measuring apparatus is provided. The electron spin resonance measuring apparatus includes: a microwave generator; the aforementioned ferromagnetic resonance measuring cavity resonator electromagnetically connected with the microwave generator; a pair of electromagnets and a pair of magnetic modulation coils provided on the sides of the ferromagnetic resonance measuring cavity resonator to provide a uniform static magnetic field within the ferromagnetic resonance measuring cavity resonator; and a microwave sensor device electromagnetically connected to the ferromagnetic resonance measuring cavity resonator for detecting a ferromagnetic resonance signal.

According to the present invention, a static magnetic field is applied at right angles to the plane of measurement of the specimen. Since the microwaves are projected through the through-hole, a precise ferromagnetic resonance signal is obtained by pressing the ferromagnetic plate on the specimen. Thus, the apparent area of measurement of the specimen is the size of the through-hole and the ferromagnetic signal is obtained without frequency changes taking place in the resonator. Particularly, when the diameter D of the through-hole is within the range of 0.0 < D ≦ 3.0 (mm), good ferromagnetic resonance results.

Since a specimen having a large area can be measured using ferromagnetic resonance on the portion facing the through-hole, ferromagnetic resonance at any given location can be measured without the need for cutting the specimen into small chips. Therefore, ferromagnetic resonance is measured in short order and the yield of chips to be used as devices is improved.

These and other objects, features and advantages of the present invention will become more apparent when the following detailed description of the present invention is considered with the drawings.

BRIEF DESCRIPTION OF THE DRAWINGS

Fig. 1 is a diagrammatic view showing a ferromagnetic resonance cavity resonator according to an embodiment of the present invention.

Fig. 2 is a diagrammatic view showing the wafer specimen pressed against the ferromagnetic resonance measuring cavity resonator of Fig. 1.

Fig. 3 is a diagrammatic view showing one example of the electron spin resonance measuring instrument for measuring the characteristics of the wafer specimen.

Figs. 4A and 4B are waveform diagrams showing ferromagnetic resonance signals when the ferromagnetic resonance measuring cavity resonator of this invention and the prior art cavity resonator are used.

Fig. 5 is a plan view showing the areas of measurement on the disk-like wafer specimen having a diameter of 76 mm.

Figs. 6A to 6E are waveform diagrams showing ferromagnetic resonance signals and linewidths corresponding to the Kittel mode at each area of measurement on the wafer specimen of Fig. 5.

DETAILED DESCRIPTION OF PREFERRED EMBODIMENTS

The inventors of the present invention studied a method of using a commercially available electron spin resonance measuring apparatus (which would require no significant modifications) to measure ferromagnetic resonance of a ferromagnetic single crystal film wafer having a narrow ferromagnetic resonance linewidth.

Specifically, a through-hole was drilled in a side wall at a position of high intensity high-frequency magnetic field of a cavity resonator. A wafer specimen was pressed into contact with the outside of the cavity resonator and the cavity resonator and the wafer specimen were electromagnetically coupled via the through-hole. Using this method, putting the specimen into the cavity resonator is unnecessary and, in principle, a wafer of a few centimeters wide can produce a ferromagnetic resonance signal without the need for cutting the wafer into small chips. Attempts were made to measure the ferromagnetic resonance linewidth of the ferromagnetic single crystal film wafer, by reducing the diameter of the through-hole in the side wall of the cavity resonator to reduce the microwaves leakage via the through-hole and reduce the apparent area of the wafer specimen.

When the wafer specimen was measured using a conventional resonator, however, a distorted signal from which the ferromagnetic resonance linewidth could not be determined was obtained. It was therefore learned that controlling the properties of the ferromagnetic single crystal film wafer was impossible in quantity production. Let $\omega$ represent the frequency of a microwave, $\gamma$, a gyromagnetic ratio, $H_i$, an internal magnetic field, $H_{ex}$, an external magnetic field, $H_d$, a diamagnetic field, and $H_a$, an anisotropy field. The equations expressing ferromagnetic resonance conditions are as follows:

$$\omega = \gamma \, H_i \qquad (1)$$

$$H_i = H_{ex} + H_d + H_a \qquad (2)$$

When a wafer specimen having a large area is placed in a static magnetic field, the internal magnetic field in the specimen is irregularly distributed rather than intersecting the plane of the specimen at right angles, and thus precise ferromagnetic resonance signals that satisfy equation (1) cannot be obtained. For this reason, it is difficult to measure a signal corresponding to the Kittel-mode that appears when the spins in the ferromagnetic material are concurrently in precession, and it is thereby difficult to determine the ferromagnetic resonance linewidth. In the case of a wafer specimen having a large area, ferromagnetic resonance is detected, but a signal that allows the ferromagnetic resonance linewidth to be determined with sufficient accuracy cannot be obtained.

In order to solve this problem, the inventors have found that it is advantageous to mount a ferromagnetic plate on the side wall of the cavity resonator so that the through-hole formed in the side wall of the cavity resonator is aligned with the through-hole formed in the ferromagnetic plate. Thus, microwaves are leaked out through the two through- holes.

When a specimen is pressed into contact with the ferromagnetic plate, the specimen and the cavity resonator are electromagnetically coupled via the through-holes. If a static magnetic field perpendicular to the plane of the specimen is applied, the through-hole of the ferromagnetic plate develops a magnetic field distribution that is lower by approximately $10^4$ A/m than the other area. In a wafer specimen having a large area, the internal magnetic field $H_i$ that satisfies equation (1) of the resonance conditions corresponds with the portion of the specimen facing the through-hole.

Since the lines of magnetic force in the through-hole are perpendicular to the plane of the wafer specimen, a uniform internal magnetic field results in the portion of the wafer specimen facing the through-hole. Therefore, ferromagnetic resonance measurements are performed only on the portion of the wafer specimen facing the through-hole. By keeping the diameter D of the through-holes formed in the cavity resonator and the ferromagnetic plate to within the range of $0.0 < D \leqq 3.0$ (mm), a good measurement is obtained. The thickness of the ferromagnetic plate may be used to control the drop in the static magnetic field in the through-hole, where the amount of drop depends on the material of the ferromagnetic plate. It is preferable that an appropriate thickness be determined which depends on the ferromagnetic plate in use.

Hereinafter, the preferred embodiments of the present invention are explained in more detail with reference to the drawings.

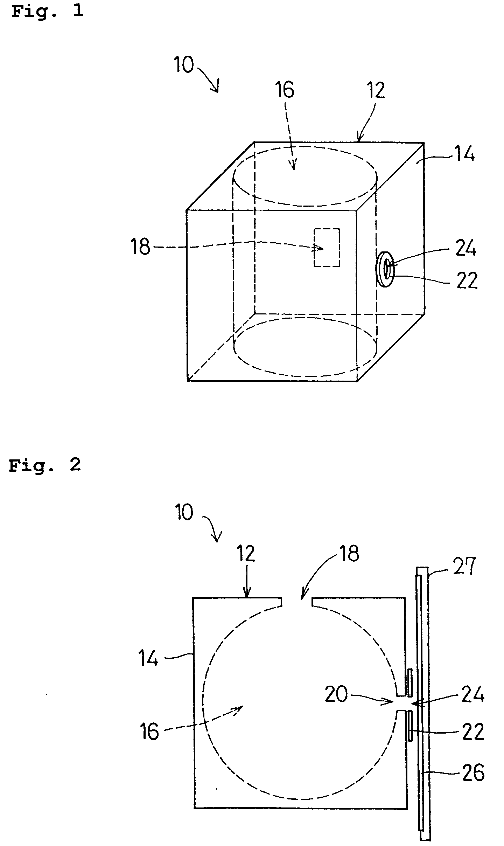

Fig. 1 is a diagrammatic view showing a ferromagnetic resonance measuring cavity resonator 10 according to an embodiment of the present invention. Fig. 2 is a diagrammatic view showing a wafer specimen that is pressed against the ferromagnetic resonance measuring cavity resonator. The ferromagnetic resonance measuring cavity resonator 10 comprises a cavity resonator 12. In this embodiment, the ES-WFCX manufactured by Nihon Denshi Co., Ltd. (a Japanese company) is used as the cavity resonator. The cavity resonator 12 comprises a side wall 14, which constitutes a cavity 16 inside. The cavity resonator 12 uses the TE011 mode and is designed to be operative in the X band (8 to 12 GHz).

The side wall 14 is provided with, for example, a square input/output hole 18 for inputting or outputting microwaves. Further, the side wall 14 is provided with a circular through-hole 20 (about 2 mm in diameter) that electromagnetically couples the cavity resonator 12 to a specimen to be measured. Mounted on the outside of the side wall 14, where the through-hole 20 is formed, is a ferromagnetic plate 22. In this embodiment, the ferromagnetic plate 22 is an iron plate having a 20 mm diameter and 0.1 mm thickness. A through-hole 24 having the same size as the through-hole 20 in the side wall 14 is present in the ferromagnetic plate 22. The ferromagnetic plate 24 is mounted on the side wall 14 so that the through-hole 20 of the side wall 14 is aligned with the through-hole 24 of the ferromagnetic plate 22.

A wafer specimen 26 is supported by a holder 27 so as to be pressed against the outside surface of the ferromagnetic plate 22. In this embodiment, the wafer specimen 26 is a disk-like gadolinium gallium garnet ($Gd_3Ga_5O_{12}$) single crystal substrate having a diameter of 76 mm on which yttrium iron garnet ($Y_3Fe_5O_{12}$) single crystal film having a thickness of 20 m is formed using the liquid phase epitaxial growth technique. The wafer specimen 26 is pressed against the through-hole 24 of the ferromagnetic plate 22. Therefore, the wafer specimen 26 is electromagnetically coupled to the cavity resonator 12 via the two through-holes 20 and 24.

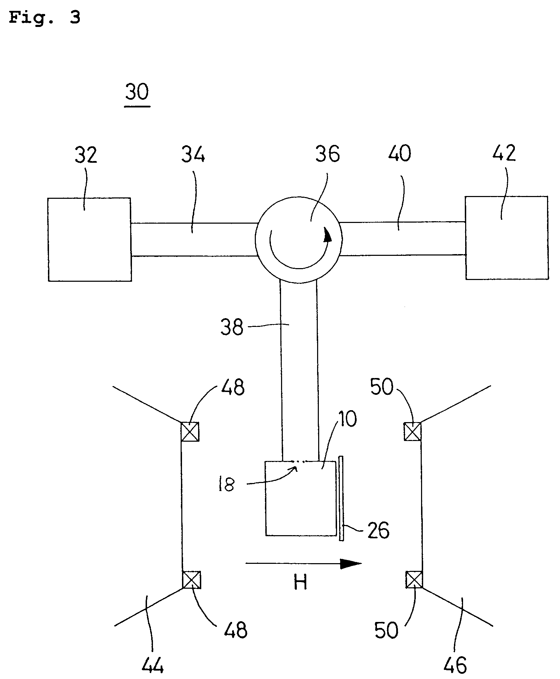

Fig. 3 shows an electron spin resonance measuring apparatus 30 according to the embodiment of the present invention. The magnetic characteristics of the wafer specimen 26 is measured using an electron spin resonance measuring instrument 30. In this embodiment, the JES-RE2X manufactured by Nihon Denshi Co., Ltd. (a Japanese company) is used as the electron spin resonance measuring instrument 30. The electron spin resonance measuring apparatus 30 comprises a microwave generator 32. The microwave generator 32 is electromagnetically connected to a circulator 36 via a waveguide 34. The circulator 36 is electromagnetically connected to the ferromagnetic resonance measuring cavity resonator 10 via a waveguide 38. The waveguide 38 is electromagnetically connected to the input/output hole 18 of the ferromagnetic resonance measuring cavity resonator 10. Therefore, the microwaves transmitted from the microwave generator 32 are introduced into the ferromagnetic resonance measuring cavity resonator 10 via the input/output hole 18.

The circulator 36 is also electromagnetically connected to a microwave sensor device 42 via a waveguide 40. The microwave sensor device 42 picks up a ferromagnetic resonance signal. The circulator 36 is used to guide the microwaves from the microwave generator 32 to the ferromagnetic resonance measuring cavity resonator 10 and to guide the ferromagnetic resonance signal from the ferromagnetic resonance measuring cavity resonator 10 to the microwave sensor device 42. Furthermore, electromagnets 44, 46 are provided on the sides of the ferromagnetic resonance measuring cavity resonator 10. The electromagnets 44, 46 are provided with magnetic modulation coils 48, 50 respectively to provide a uniform static magnetic field to the cavity resonator 12.

In the electron spin resonance measuring apparatus 30, the microwave generator 32 feeds a fixed wavelength microwave signal to the ferromagnetic resonance measuring cavity resonator 10. The electromagnets 44, 46 apply the static magnetic field to the ferromagnetic resonance measuring cavity resonator 10, and the microwave sensor device 42 detects a ferromagnetic resonance signal that is generated when ferromagnetic resonance takes place.

Although a uniform static magnetic field is applied to the outside of the wafer specimen, it is usually difficult to obtain a uniform internal magnetic field within the wafer specimen. In the ferromagnetic resonance measuring cavity resonator 10 of the present invention, however, the ferromagnetic plate 22 causes a static magnetic field to develop within the through-hole 24 that is lower, by approximately $10^4$ A/m, than that in the remaining portion. Further, uniform lines of magnetic force in perpendicular relation to the plane of the specimen are obtained. As a result, a uniform internal magnetic field distribution that intersects the plane of the specimen at right angles exists through the area of the wafer specimen 26 facing the through-hole 24. Therefore, a precise ferromagnetic resonance signal is derived from the area of the wafer specimen 26 facing the through-hole 24.

Since the area of measurement faces the through-hole 24, the apparent area of measurement is reduced to the diameter of the through-hole 24 even when the wafer specimen 26 has a larger area. This arrangement works the same way as when a small chip is used as a specimen and is positioned inside the cavity resonator 12, whereby frequency changes in the cavity resonator 12 during ferromagnetic resonance are prevented. Therefore, even when the wafer specimen 26 having a larger area is measured, the wafer specimen 26 may be measured at any arbitrary location by shifting the wafer specimen 26 relative to the through-hole 24 of the ferromagnetic plate 22.

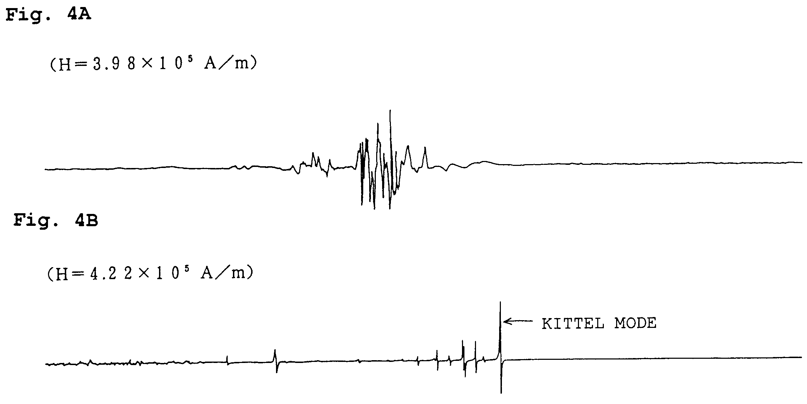

As an example, ferromagnetic resonance signals were measured with and without the ferromagnetic plate 22, and the test results are shown in Figs. 4A and 4B. Fig. 4A shows the test result without the ferromagnetic plate 22, and Fig. 4B shows the test result with the ferromagnetic plate 22 employed. The signal corresponding to the Kittel-mode that appears when the spins in the ferromagnetic material are concurrently in precession is normally detected at a high level and a high magnetic field position. In Fig. 4A, the ferromagnetic resonance signal is detected at a microwave frequency of 9.54 GHz, but the Kittel mode signal cannot be observed. In contrast, in Fig. 4B, the signal corresponding to the Kittel mode is detected at a high level, and thus measurement of the resonance magnetic field and ferromagnetic resonance linewidth ($\Delta H$) is possible.

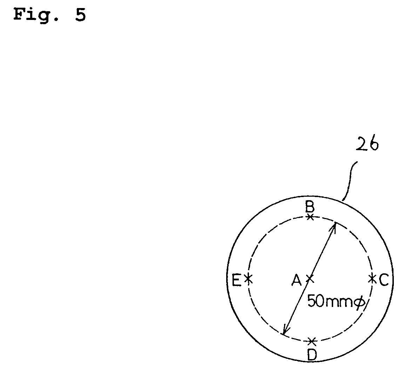

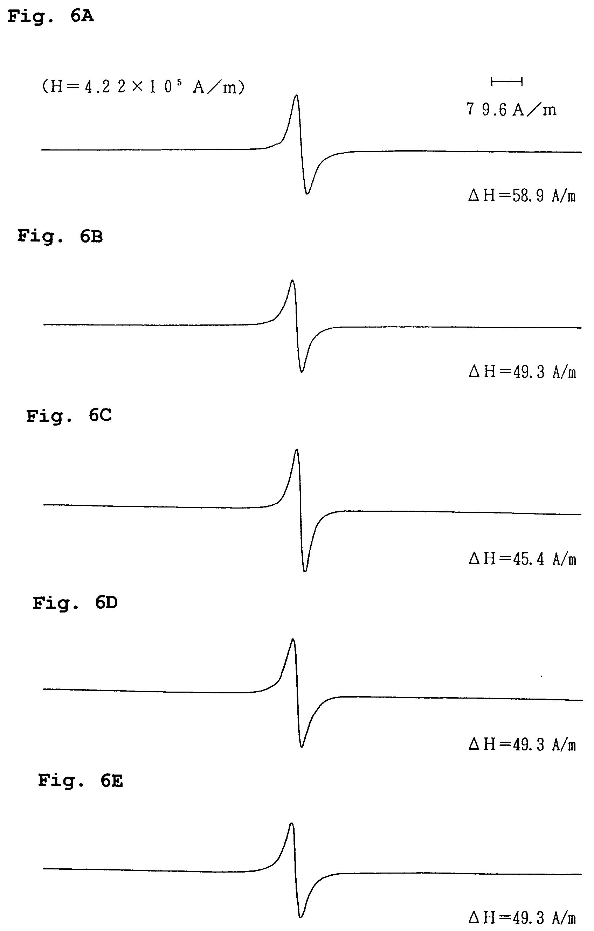

Furthermore, ferromagnetic resonance signals and the linewidths corresponding to the Kittel mode were measured at a plurality of locations on the wafer specimen 26. As shown in Fig. 5, ferromagnetic resonance signals were measured at a center point A of the wafer specimen 26 (having a 76 mm diameter) and four areas B, C, D and E spaced along a circle of 50 mm diameter centered at point A. Test results are shown in Figs. 6A to 6E. For the wafer specimen 26 used in this test, each area exhibited a narrow ferromagnetic resonance linewidth which confirmed that a high-quality single crystal was formed. Further, a chip of 1 mm by 1 mm was cut from the wafer specimen and the ferromagnetic resonance was measured. A nearly identical ferromagnetic resonance linewidth was obtained.

As described above, using the electron spin resonance measuring instrument 30 having the ferromagnetic resonance measuring cavity resonator 10 of the present invention, the wafer specimen 26 having a large area may be measured at any arbitrary location for ferromagnetic resonance linewidth ($\Delta H$). Therefore, cutting the wafer specimen 26 into small chips for the purpose of the measurement of magnetic characteristics is not required. Thus, the characteristics are efficiently measured and the yield of chips to be used as devices is enhanced. Although in the above embodiment, an iron plate was used as the ferromagnetic plate 22, it was found that other materials may be used as long as they are ferromagnetic materials.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

## Claims

1. A ferromagnetic resonance measuring cavity resonator (10) for use in measuring electron spin resonance of a ferromagnetic material, comprising:

    a cavity resonator (12) having a cavity (16) formed by a side wall (14), the side wall (14) provided with a through-hole (20) and an input/output hole (18); and
    a ferromagnetic plate (22) having therein a through-hole (24), the ferromagnetic plate (22) mounted on the side wall (14) of the cavity resonator (12) so that the through- hole (20) formed in the side wall (14) of the cavity resonator (12) is aligned with the through-hole (24) formed in the ferromagnetic plate (22).

2. The ferromagnetic resonance measuring cavity resonator (10) according to claim 1, wherein the through-hole (24) of the ferromagnetic plate (22) has substantially the same diameter as the through-hole (20) of the side wall (14).

3. The ferromagnetic resonance measuring cavity resonator (10) according to claim 2, wherein the diameter D of the through-hole (20) formed in the side wall (14) of the cavity resonator (12) and the through-hole (24) formed in the ferromagnetic plate (22) is within a range of 0.0 mm < D ≦ 3.0 mm, and preferably about 2 mm.

4. The ferromagnetic resonance measuring cavity resonator (10) according to any of the preceding claims, wherein said cavity resonator (12) is sized for operation in the transverse electric mode and a frequency of 8 to 12 Ghz.

5. The ferromagnetic resonance measuring cavity resonator (10) according to any of the preceding claims, wherein said ferromagnetic plate (22) is iron.

6. The ferromagnetic resonance measuring cavity resonator (10) according to claim 5, wherein the diameter of said ferromagnetic plate (22) is about 20 mm and the thickness of said ferromagnetic plate (22) is about 0.1 mm.

7. An electron spin resonance measuring apparatus (30) comprising:

a microwave generator (32);
a ferromagnetic resonance measuring cavity resonator (10) electromagnetically connected with the microwave generator (32), the ferromagnetic resonance measuring cavity resonator (10) including: a cavity resonator (12) having a cavity (16) formed by a side wall (14), the side wall (14) provided with a through-hole (20) and an input/output hole (18), a ferromagnetic plate (22) having therein a through-hole (24) and mounted on the side wall (14) of the cavity resonator (12) so that the through-hole (20) formed in the side wall (14) of the cavity resonator (12) is aligned with the through-hole (24) formed in the ferromagnetic plate (22), and a holder (27) for supporting a wafer specimen (26) such that the wafer (26) is pressed against an outside surface of the ferromagnetic plate (22);
a first electromagnet (44) and a first magnetic modulation coil (48) provided on one side of the ferromagnetic resonance measuring cavity resonator (10) and a second electromagnet (46) and a second magnetic modulation coil (50) provided on another side of the ferromagnetic resonance measuring cavity resonator (10) to provide a uniform static magnetic field to the ferromagnetic resonance measuring cavity resonator (10);
a microwave sensor device (42), electromagnetically connected with the ferromagnetic resonance measuring cavity resonator (10), for detecting a ferromagnetic resonance signal.

8. The electron spin resonance measuring apparatus (30) according to claim 7, wherein the through-hole (24) of the ferromagnetic plate (22) has substantially the same diameter as the through-hole (20) of the side wall (14).

9. The electron spin resonance measuring apparatus (30) according to claim 8, wherein the diameter D of the through-hole (20) formed in the side wall (14) of the cavity resonator (12) and the through-hole (24) formed in the ferromagnetic plate (22) is within a range of $0.0 \text{ mm} < D \le 3.0 \text{ mm}$, and preferably about 2 mm.

10. The electron spin resonance measuring apparatus (30) according to any of the claims 7 to 9, wherein said cavity resonator (12) is sized for operation in the transverse electric mode and a frequency of 8 to 12 Ghz.

11. The electron spin resonance measuring apparatus (30) according to any of the claims 7 to 10, wherein said ferromagnetic plate (22) is iron.

12. The electron spin resonance measuring apparatus (30) according to claim 11, wherein the diameter of said ferromagnetic plate (22) is about 20 mm and the thickness of said ferromagnetic plate (22) is about 0.1 mm.

13. The electron spin resonance measuring apparatus (30) according to any of the claims 7 to 12, further comprising a circulator (36) which couples said microwave generator and said microwave sensing device (42) to said ferromagnetic resonance measuring cavity resonator (10).

Fig. 1

Fig. 2

Fig. 3

Fig. 4A

$(H = 3.98 \times 10^5 \ A/m)$

Fig. 4B

$(H = 4.22 \times 10^5 \ A/m)$

← KITTEL MODE

Fig. 5

**Fig. 6A**

$(H = 4.2\,2 \times 1\,0^{5}\ A/m)$

$7\,9.6\,A/m$

$\triangle H = 58.9\ A/m$

**Fig. 6B**

$\triangle H = 49.3\ A/m$

**Fig. 6C**

$\triangle H = 45.4\ A/m$

**Fig. 6D**

$\triangle H = 49.3\ A/m$

**Fig. 6E**

$\triangle H = 49.3\ A/m$

| | European Patent Office | EUROPEAN SEARCH REPORT | Application Number |
|---|---|---|---|
| | | | EP 96 11 0526 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,X | IEEE TRANSACTIONS ON MAGNETICS, vol. 25, no. 5, 1989, pages 3488-3490, XP002014672 J.D. ADAMS ET AL.: "Non-Destructive Evaluation of YIG Films by Ferromagnetic Resonance" | 1,4,5,7, 10,11,13 | G01R33/345 H01P1/215 |
| A | * the whole article * | 2,3,6,8, 9,12 | |
| A | IEEE TRANSACTIONS ON MAGNETICS, vol. 23, no. 5, 1987, pages 3340-3342, XP002014673 SH. TAKEDA: "Non-Destructive delta H Measurement..." * the whole article * | 1-13 | |
| A | US-A-4 547 754 (Y. MURAKAMI, H. YAMADA) * column 1, line 41 - column 4, line 56 * | 1,7 | |
| | | | TECHNICAL FIELDS SEARCHED (Int.Cl.6) |
| | | | G01R H01P |

The present search report has been drawn up for all claims

| Place of search | Date of completion of the search | Examiner |
|---|---|---|
| THE HAGUE | 30 September 1996 | Volmer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)